# FASCICULE DE BREVET EUROPEEN

(11) **EP 3 066 044 B1**
(45) Date de publication et mention de la délivrance du brevet: **10.06.2020**
(21) Numéro de dépôt: 14780862.0
(22) Date de dépôt: 06.10.2014
(51) Int. Cl.: B81C 99/00

(54) **PIÈCE DE MICROMÉCANIQUE CREUSE, À PLUSIEURS NIVEAUX FONCTIONNELS ET MONOBLOC EN UN MATÉRIAU À BASE D'UN ALLOTROPE SYNTHÉTIQUE DU CARBONE**
HOHLES MIKROMECHANISCHES BAUTEIL MIT MEHREREN FUNKTIONSEBENEN, UND MONOBLOCK AUS EINEM MATERIAL AUF DER BASIS EINES SYNTHETISCHEN KOHLENSTOFFALLOTROPS
HOLLOW MICROMECHANICAL PART WHICH HAS A PLURALITY OF FUNCTIONAL LEVELS AND IS UNITARY MADE OF A MATERIAL COMPRISING A SYNTHETIC CARBON ALLOTROPE

(30) Priorité: 08.11.2013 EP 13192133
(43) Date de publication de la demande: 14.09.2016
(73) Titulaire: Nivarox-FAR S.A., 2400 Le Locle (CH)
(72) Inventeur: DUBOIS, Philippe, CH-2074 Marin (CH); MERZAGHI, Sebastiano, CH-1018 Lausanne (CH); CHARBON, Christian, CH-2054 Chézard-St-Martin (CH)
(74) Mandataire: Goulette, Ludivine
(86) Numéro de dépôt international: PCT/EP2014/071301
(87) Numéro de publication internationale: WO 2015/067419

(56) Documents cités:
- US-A- 5 242 711
- US-A1- 2010 054 089
- US-A1- 2012 199 996
- US-A1- 2013 167 606
- US-A1- 2013 213 800

## Description

### Domaine de l'invention

L'invention se rapporte à un procédé de fabrication d'une pièce de micromécanique et plus précisément à une telle pièce monobloc en matériau à base d'un allotrope synthétique du carbone comportant plusieurs niveaux fonctionnels.

### Arrière-plan de l'invention

Les documents US 2012/0199996 et WO 2012/104110 divulgent la fabrication de pièce en diamant à un seul niveau formé à partir d'un substrat en silicium. Une telle pièce peut être toutefois difficile à rendre solidaire d'un pivot ou d'une autre pièce en ce que le diamant ne peut pas être chassé.

### Résumé de l'invention

Le but de la présente invention est de pallier tout ou partie les inconvénients cités précédemment en proposant un procédé permettant la fabrication des pièces de micromécanique monoblocs complexes en trois dimensions utilisant une quantité minimale de matériau.

A cet effet, l'invention se rapporte à un procédé de fabrication d'une pièce de micromécanique creuse en un matériau monobloc à base d'un allotrope synthétique du carbone, le procédé comportant les étapes suivantes :
a) former un substrat comportant sur au moins trois niveaux une empreinte négative de ladite pièce de micromécanique à fabriquer ;
b) recouvrir ladite empreinte négative du substrat d'une couche dudit matériau à base d'un allotrope synthétique du carbone d'une épaisseur inférieure à la profondeur de chacun desdits au moins trois niveaux de ladite empreinte ;
c) retirer le substrat afin de laisser libre la pièce de micromécanique creuse monobloc formée dans ladite empreinte négative.
caractérisé en ce que l'étape a) comporte les phases suivantes :
i)former une première plaquette comportant au moins un premier motif gravé traversant ;
ii) former une deuxième plaquette comportant au moins un deuxième motif gravé traversant ;
iii) former une troisième plaquette ne comportant aucun motif traversant ;
iv) solidariser lesdites première, deuxième et troisième plaquettes afin de former le substrat comportant une empreinte négative sur au moins trois niveaux.

On comprend donc que le procédé autorise la fabrication d'une pièce de micromécanique en trois dimensions, c'est-à-dire à plusieurs niveaux fonctionnels, à base d'un allotrope synthétique du carbone monobloc, c'est-à-dire sans discontinuité de matière, qui comporte une « peau » de matériau, c'est-à-dire peu de matériau. De plus, de manière additionnelle, la surface externe de la pièce de micromécanique reprend la rugosité favorable du substrat.

Le procédé selon l'invention permet donc avantageusement de diminuer très sensiblement le coût du matériau à base d'un allotrope synthétique du carbone en ne déposant que la quantité de matière nécessaire au revêtement final sans qu'une opération de retouche soit rendue nécessaire et permet également d'améliorer la rugosité de la surface externe de la pièce de micromécanique pour parfaire sa tribologie.

Conformément à d'autres caractéristiques avantageuses de l'invention :
- lors de la phase ii), la deuxième plaquette est formée en comportant un deuxième motif gravé traversant et un troisième motif gravé non traversant et communiquant avec ledit deuxième motif ;
- lors de la phase iii), la troisième plaquette est formée en comportant un motif gravé non traversant ;
- Selon une première alternative, l'étape b) comporte les phases b1) : former une couche sacrificielle sur une partie du substrat, b2) : déposer des particules sur le substrat destinées à former des lieux de germination, b3) : retirer la couche sacrificielle afin de laisser sélectivement libre de toute particule, une partie du substrat, b4) : déposer, chimiquement en phase vapeur, une couche d'un allotrope synthétique du carbone afin qu'elle se dépose uniquement où subsistent les particules ;
- Selon une deuxième alternative, l'étape b) comporte les phases b5) : former une couche sacrificielle sur une partie du substrat, b6) : déposer, chimiquement en phase vapeur, une couche d'un allotrope synthétique du carbone sur le substrat et b7) : retirer la couche sacrificielle afin de laisser sélectivement libre de tout dépôt, une partie du substrat ;
- au moins l'un desdits au moins trois niveaux de l'empreinte négative comporte une paroi formant une denture ;
- le matériau à base d'un allotrope synthétique du carbone est sous forme cristallisée ou sous forme amorphe ;
- le procédé comporte, après l'étape b), l'étape d) : retirer du substrat une épaisseur supérieure à celle de la couche déposée lors de l'étape b) afin de laisser une épaisseur de ladite couche circonscrite dans ladite empreinte négative ;
- le procédé comporte, avant l'étape c), l'étape e) : remplir l'empreinte revêtue du matériau à base d'un allotrope synthétique du carbone avec un deuxième matériau afin qu'après l'étape c), on obtienne une pièce de micromécanique en un matériau à base d'un allotrope synthétique du carbone renforcé et/ou décoré par un deuxième matériau ;
- lors de l'étape e), le deuxième matériau est formé en saillie de ladite empreinte afin de former un niveau fonctionnel supplémentaire à la pièce de micromécanique ;
- le deuxième matériau comporte un métal ou un alliage métallique.

De plus, l'invention se rapporte à une pièce de micromécanique creuse obtenue à partir du procédé selon l'une des variantes précédentes, caractérisée en ce que la pièce de micromécanique est creuse, comporte plusieurs niveaux fonctionnels formés de manière monobloc en matériau à base d'un allotrope synthétique du carbone selon une couche d'épaisseur comprise entre 0,2 µm et 20 µm et comprend une hauteur supérieure à l'épaisseur de la couche en matériau à base d'allotrope synthétique du carbone.

La pièce de micromécanique à base d'un allotrope synthétique du carbone est avantageusement monobloc, c'est-à-dire sans discontinuité de matière, creuse, c'est-à-dire formée par une coque du matériau pour limiter la quantité de matériau utilisé, dont le volume forme plusieurs niveaux fonctionnels parfaitement référencés et pouvant comporter directement un axe de pivotement.

On comprend que cela permet de faire chuter le taux de rebut lié au défaut de référencement mais également d'améliorer la rugosité de la surface externe pour parfaire sa tribologie.

Conformément à d'autres caractéristiques avantageuses de l'invention :
- la surface externe de la pièce de micromécanique comporte au moins une denture ;
- le creux de la pièce de micromécanique est au moins partiellement rempli avec un deuxième matériau afin d'obtenir une pièce de micromécanique en matériau à base d'un allotrope synthétique du carbone renforcé et/ou décoré par un deuxième matériau ;
- ledit deuxième matériau est formé en saillie de ladite hauteur de la surface externe afin de former un élément fonctionnel supplémentaire à la pièce de micromécanique ;
- le deuxième matériau comporte un métal ou un alliage métallique.

Enfin, l'invention se rapporte à une pièce d'horlogerie caractérisée en ce qu'elle comporte une pièce de micromécanique selon l'une des variantes précédentes, la pièce de micromécanique formant tout ou partie d'une glace, d'un boîtier, d'un poussoir, d'une couronne, d'un bracelet, d'un cadran, d'un afficheur, d'un spiral, d'un balancier, d'une ancre, d'un pont, d'une platine, d'un mobile ou d'une roue d'échappement.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 8 sont des représentations d'étapes successives d'un procédé de fabrication selon un premier mode de réalisation ;
- la figure 9 est une représentation d'un exemple de pièce de micromécanique obtenue selon un premier mode de réalisation ;
- les figures 10 à 12 sont des représentations d'étapes successives d'un procédé de fabrication selon un deuxième mode de réalisation ;
- la figure 13 est une représentation d'un exemple de pièce de micromécanique obtenue selon un deuxième mode de réalisation ;
- les figures 14 et 15 sont des représentations d'étapes successives d'un procédé de fabrication selon un troisième mode de réalisation ;
- la figure 16 est une représentation d'un exemple de pièce de micromécanique obtenue selon un troisième mode de réalisation ;
- les figures 17 et 18 sont des représentations d'étapes successives d'un procédé de fabrication selon une alternative des figures 1 et 2 du premier mode de réalisation ;
- les figures 19 à 22 sont des représentations d'étapes successives d'un procédé de fabrication selon un quatrième mode de réalisation de l'invention ;
- les figures 23 à 26 sont des représentations d'étapes successives d'un procédé de fabrication selon un cinquième mode de réalisation de l'invention ;
- la figure 27 est une représentation de deux exemples de pièces de micromécanique obtenue selon les quatrième et cinquième modes de réalisation de l'invention.

### Description détaillée des modes de réalisation préférés

L'invention se rapporte à un procédé de fabrication d'une pièce de micromécanique monobloc à plusieurs niveaux fonctionnels en un matériau à base d'un allotrope synthétique du carbone sous forme cristalline, comme du diamant ou une ou plusieurs couches de graphène, ou sous forme amorphe, comme du DLC (abréviation provenant des termes anglais « Diamond Like Carbon »).

Bien entendu, avantageusement selon l'invention, d'autres types de matériaux, qui sont déposables sous forme de couche et qui présentent un intérêt tribologique, peuvent être utilisés alternativement à un allotrope synthétique du carbone. Un tel matériau alternatif peut, par exemple, être un composé à base de silicium, c'est-à-dire par exemple du nitrure de silicium, de l'oxyde de silicium ou du carbure de silicium.

Cette pièce de micromécanique a été imaginée pour des applications dans le domaine horloger. Toutefois, d'autres domaines peuvent parfaitement être imaginés comme notamment l'aéronautique, la bijouterie ou l'automobile.

Dans le domaine horloger, cette pièce de micromécanique peut, à titre d'exemple, former une partie de l'habillage ou une partie du mouvement horloger. La pièce de micromécanique peut ainsi former tout ou partie d'une glace, d'un boîtier, d'un poussoir, d'une couronne, d'un bracelet, d'un cadran, d'un afficheur, d'un spiral, d'un balancier, d'une ancre, d'un pont, d'une platine, d'un mobile ou d'une roue d'échappement.

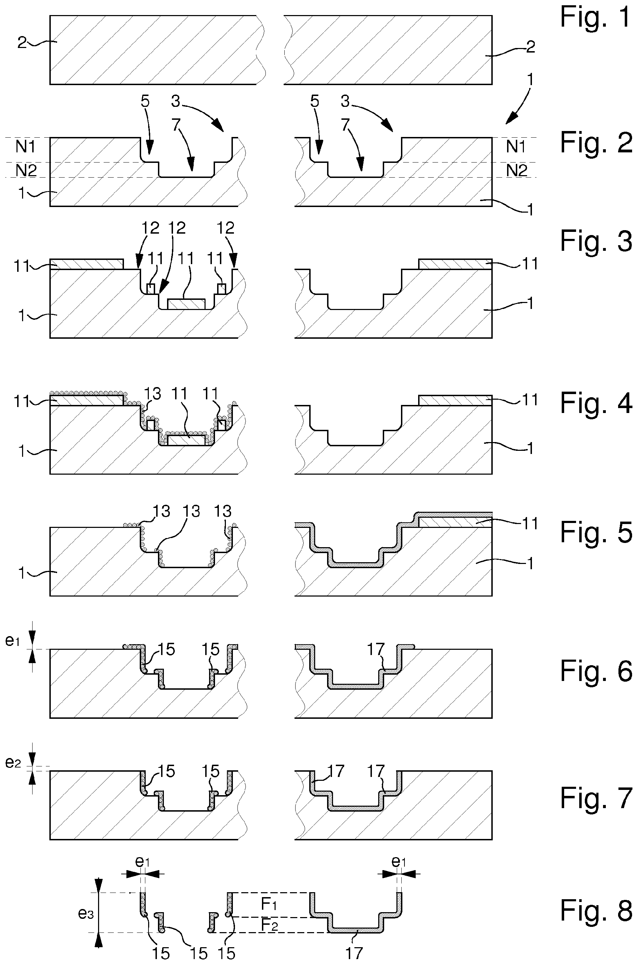

Un premier mode de réalisation d'un procédé de fabrication d'une telle pièce de micromécanique est présenté aux figures 1 à 8 et 17 à 18. Dans une étape a, le procédé consiste à former, dans un substrat 1, 101, sur au moins deux niveaux N₁, N₂, Nₓ, une empreinte 3, 103 négative de la future pièce de micromécanique. Une grande variété de substrats 1, 101 est possible. Préférentiellement, la matière du substrat 1, 101 est choisie pour sa très faible rugosité, c'est-à-dire son caractère naturel à présenter une surface lisse mais également pour sa résistance quant à l'agressivité des étapes de dépôt.

A titre d'exemple, les figures 1, 2, 17 et 18 présentent l'étape a formée à partir d'un substrat 1, 101 en silicium pour lequel il est possible d'obtenir une très faible rugosité, c'est-à-dire un écart moyen arithmétique Rₐ sensiblement inférieur à 10 nm.

Ainsi, dans une première alternative de l'étape a illustrée aux figures 1 et 2, le substrat 1, comportant une empreinte 3 sur au moins deux niveaux N₁, N₂, Nₓ, est formé à partir d'une plaquette unique 2.

La première alternative de l'étape a utilise donc plusieurs masques afin d'obtenir plusieurs motifs de gravage à des profondeurs différentes. Ainsi, une première phase a1 de l'étape a est destinée à former, sur le substrat 1, un premier masque comportant un premier motif. Une deuxième phase a2 est destinée à former, sur la surface dudit substrat et du premier masque, un deuxième masque comportant un deuxième motif plus petit que le premier motif dudit premier masque afin de pouvoir graver deux motifs distincts dans le substrat.

La première alternative de l'étape a se poursuit avec la troisième phase a3 consistant à réaliser une attaque anisotrope (comme par exemple un gravage ionique réactif profond -DRIE-) afin de graver selon le deuxième motif sur une première épaisseur du substrat puis une quatrième phase a4 destinée à retirer le deuxième masque. En variante, l'épaisseur et le matériau du deuxième masque peuvent être choisi afin que le deuxième masque soit gravé en même temps que le substrat afin de coupler en une phase unique les phases a3 et a4 ci-dessus. On comprend que le motif qui sera gravé sur le niveau N₂ est pour l'instant uniquement gravé sur le niveau N₁.

La première alternative de l'étape a se poursuit avec la cinquième phase a5 consistant à réaliser une deuxième attaque anisotrope afin de continuer la gravure selon le deuxième motif, déjà effectuée dans le niveau N₁, dans le niveau N₂ et commencer la gravure selon le premier motif dans le niveau N₁ du substrat 1, c'est-à-dire élargir la gravure du deuxième motif vers le premier motif dans le niveau N₁. La première alternative de l'étape a se termine, dans le cas d'une gravure à deux niveaux, en une dernière phase a6 destinée à retirer le premier masque afin de former le substrat 1 comportant une empreinte 3 négative sur au moins deux niveaux N₁, N₂.

En variante, le substrat pourrait être un S.O.I., c'est-à-dire comporter deux couches de silicium reliées par une couche de dioxyde de silicium. L'une des couches de silicium pourrait alors subir l'étape a et le fond de l'empreinte 3 négative sur au moins deux niveaux N₁, N₂ être formée par la couche de dioxyde de silicium de manière plus précise. En effet, l'attaque de l'étape a étant très sélective, elle ne peut pas graver la couche de dioxyde de silicium. On comprend que le fond de l'empreinte sera plus facilement contrôlé.

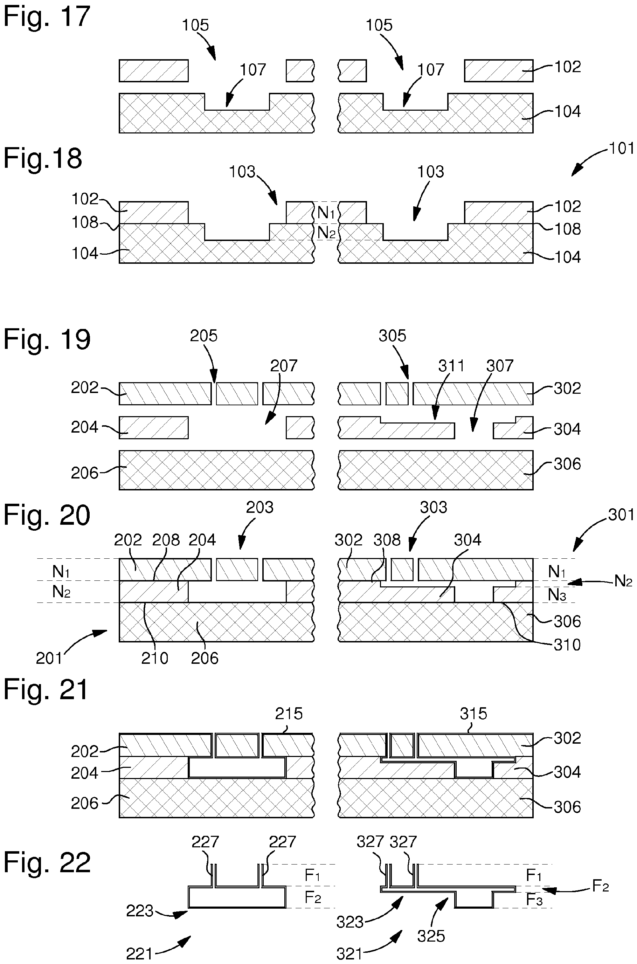

Dans une deuxième alternative de l'étape a illustrée aux figures 17 et 18, le substrat 101, comportant une empreinte 103 sur au moins deux niveaux N₁, N₂, Nₓ, est formé dans autant de plaquettes 102, 104 que de niveaux requis. Cette deuxième alternative est préférée dans le cas où plus de deux niveaux sont souhaités comme expliqué ci-dessous pour les quatrième et cinquième modes de réalisation.

La deuxième alternative de l'étape a utilise donc plusieurs plaquettes gravées directement selon le motif requis pour son niveau N₁, N₂, Nₓ, associé. Ainsi, dans la deuxième alternative de l'étape a sur deux niveaux N₁, N₂, une première phase a7 est destinée à former une première plaquette 102 comportant au moins un premier motif 105 gravé traversant et une deuxième phase a8 consistant à former une deuxième plaquette 104 comportant au moins un deuxième motif 107 gravé non traversant. Dans une dernière phase a9, l'étape a selon la deuxième alternative se termine en solidarisant les première 102 et deuxième 104 plaquettes afin de former le substrat 101 comportant une empreinte 103 négative sur au moins deux niveaux N₁, N₂, formée respectivement des premier 105 et deuxième 107 motifs. De manière préférée, la phase a9 de solidarisation est réalisée par « fusion bonding » et forme une couche 108.

Après l'une des deux alternatives de l'étape a, le premier mode de réalisation se poursuit avec l'étape b destinée à recouvrir l'empreinte 3, 103 négative du substrat 1, 101 d'une couche 15, 17 du matériau à base d'un allotrope synthétique du carbone d'une épaisseur e₁ inférieure à la profondeur de chacun desdits au moins deux niveaux N₁, N₂, Nₓ, de ladite empreinte 3, 103.

Avantageusement selon l'invention, l'étape b peut également comporter deux alternatives suivant la complexité géométrique requise pour la couche 15, 17 du matériau à base d'un allotrope synthétique du carbone.

Dans une première alternative de la deuxième étape b illustrée dans la partie gauche de la figure 3, la première phase b1 est destinée à former une couche sacrificielle 11 sur une partie du substrat 1. On comprend que le substrat 1 présente donc des zones 12 non recouvertes. Préférentiellement, l'étape b1 est réalisée par une photolithographie d'une résine photosensible du type négatif ou positif. En variante, une sérigraphie, ou une tampographie, peut être réalisée pour déposer selon un motif particulier une épaisseur du matériau destiné à former la couche sacrificielle.

Comme illustré à la figure 4, la première alternative de la deuxième étape b se poursuit avec la deuxième phase b2 destinée à déposer des particules 13 sur le substrat 1 destinées à former des lieux de germination pour le futur dépôt. Préférentiellement, la deuxième phase b2 comporte un premier temps destiné à enduire le substrat 1 à l'aide d'une solution colloïdale comportant lesdites particules. L'enduction peut ainsi être obtenue par l'immersion au moins partielle du substrat 1 dans une solution dont les particules sont volontairement rendues mobiles dans le solvant afin d'obtenir une répartition la plus homogène possible dans la solution. A titre d'exemple, leur mobilité dans le solvant peut être apportée par une agitation du type à ultrasons. Enfin, sans être limitatif, le solvant peut consister en de l'alcool ou de l'eau.

Les particules 13 sont utilisées comme lieux de germination. A ce titre, les particules peuvent être des impuretés vis-à-vis du matériau du futur dépôt, tout comme elles peuvent être de la même nature que le matériau du futur dépôt. Préférentiellement, le diamètre des particules est compris entre quelques nanomètres à quelques dizaines de nanomètres.

La phase b2 se poursuit avec un deuxième temps destiné à retirer le solvant de la solution pour former les particules 13 sur le substrat 1. Ce deuxième temps peut être par exemple obtenu par vaporisation du solvant.

La deuxième phase b2 est suivie par une troisième phase b3 illustrée à la figure 5 consistant à retirer la couche sacrificielle 11 du substrat 1 afin de laisser sélectivement libre de toute particule 13, une partie du substrat 1. On comprend donc que les parties où figurent les particules 13 correspondent aux zones où n'était pas présente la couche sacrificielle 11. La phase b3 peut, à titre non limitatif, être obtenue par une dissolution ou une attaque chimique sélective de la couche sacrificielle 11.

Une quatrième phase b4 de la première alternative de la deuxième étape b est destinée à déposer un matériau 15 chimiquement en phase vapeur afin qu'il se dépose exclusivement où subsistent les particules 13. A la fin de l'étape b, comme illustré à la figure 6, on obtient un substrat 1 formé directement avec la couche partielle de matériau 15 désirée. On comprend que la première alternative de la deuxième étape b permet donc de former une pièce de micromécanique partiellement ajourée.

Dans une deuxième alternative de la deuxième étape b illustrée dans la partie droite de la figure 5, la phase b6 se limite à déposer un matériau 17 chimiquement en phase vapeur sans aucune sélectivité, c'est-à-dire sur toute la face supérieure. A ce titre, une phase antérieure b5 illustrée dans la partie droite de la figure 3 (similaire à celle b1 de la première alternative) et une phase postérieure b7 illustrée dans la partie droite la figure 6 (similaire à la phase b3 de la première alternative) peuvent être mise en œuvre afin de limiter la présence de la couche 17 notamment sur la surface supérieure du substrat 1. A la fin de l'étape b, comme illustré à la figure 6, on obtient un substrat 1 formé directement avec la couche de matériau 17 désirée. On comprend que la deuxième alternative de la deuxième étape b permet donc de former une pièce de micromécanique sans ajourage de la surface externe de la pièce de micromécanique.

Quelle que soit l'alternative utilisée pour la deuxième étape b, le procédé, comme illustré à la figure 7, peut comporter une troisième étape optionnelle d. L'étape d est destinée à retirer une partie du substrat 1 revêtu de la couche 15, 17 afin de laisser une épaisseur de la couche 15, 17 circonscrite dans l'empreinte négative 3 à au moins deux niveaux. Préférentiellement, on enlève une épaisseur e₂ du substrat 1 supérieure à celle e₁ de la couche 15, 17 comme illustré à la figure 7. On comprend donc qu'à coup sûr, la couche 15, 17 n'est plus présente que dans l'empreinte 3 à au moins deux niveaux du substrat 1.

De plus, on s'aperçoit également que l'étape d peut être équivalente aux phases b1, b5 et b3, b7 pour circonscrire la couche 15, 17 dans l'empreinte 3. En effet, il suffit de former une couche sacrificielle 11 partout sur le substrat 1 sauf au niveau de l'empreinte 3 pour obtenir le même résultat.

Dans une dernière étape c du premier mode de réalisation, le procédé consiste à retirer le substrat 1 afin de libérer la pièce de micromécanique à plusieurs niveaux fonctionnels F₁, F₂, Fₓ, formée au moins partiellement dans l'empreinte 3. Par conséquent, dans l'exemple ci-dessus dans lequel le substrat 1 est en silicium, l'étape c peut consister en une attaque sélective du silicium. Cela peut, par exemple, être obtenu par une attaque chimique au moyen d'un bain comportant de l'hydroxyde de tétra-méthyl-ammonium (connu sous les abréviations TMAH et TMAOH). En variante, une attaque chimique à base d'hydroxyde de potassium est également envisageable (connu sous l'abréviation KOH).

Dans les deux exemples illustrés à la figure 8, on obtient une pièce de micromécanique formée exclusivement par la couche 15, 17 de géométrie au moins partiellement correspondante à l'empreinte 3, c'est-à-dire totalement ou partiellement. Avantageusement, la surface externe, c'est-à-dire la surface qui était directement en contact avec le substrat 1, comporte une très faible rugosité, c'est-à-dire comparable à celle du substrat 1, et est, préférentiellement, utilisée comme surface de contact mécanique.

Enfin, pour une hauteur e₃ de la pièce de micromécanique à deux niveaux comprise entre 20 µm et 1000 µm, seule une épaisseur e₁ de la couche 15, 17 comprise entre 0,2 µm et 20 µm est déposée. On comprend donc immédiatement les gains en coût de matière et en coût de production dû au temps raccourci de l'étape b de dépôt.

Ainsi, quelle que soit la complexité de la pièce de micromécanique, le procédé n'est pas plus difficile à mettre en œuvre. A titre d'exemple, il n'est pas plus difficile de former une denture sur une paroi de l'empreinte 3 qui formera une denture correspondante sur la pièce de micromécanique.

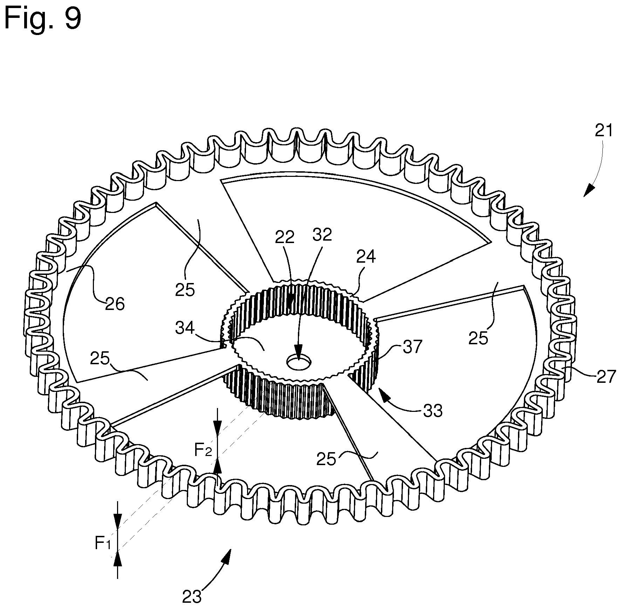

A titre d'exemple nullement limitatif dans lequel on aurait appliqué la première alternative de la deuxième étape b, on pourrait obtenir une pièce de micromécanique 21 comme présentée à la figure 9. La pièce de micromécanique 21 comporte un premier niveau fonctionnel F₁ composé d'une première planche 23 sensiblement discoïdale dont le centre comporte un trou 22 communiquant avec un deuxième niveau fonctionnel F₂. De plus, coaxialement au trou 22, le premier niveau fonctionnel F₁ s'étend un moyeu 24 reliant plusieurs bras 25 à la serge 26 à partir de la périphérie de laquelle se projette orthogonalement une denture 27. A la figure 9, on s'aperçoit donc que l'épaisseur de la planche 23, c'est-à-dire du moyeu 24, des bras 25 et de la serge 26, ainsi que de la denture 27 sont formées par l'épaisseur e₁ de la couche 15 déposée lors de l'étape b du procédé.

En outre, la pièce de micromécanique 21 comporte un deuxième niveau fonctionnel F₂ composé d'une deuxième planche 33 sensiblement discoïdale dont le centre comporte un trou 32 permettant de coopérer avec un axe. De plus, coaxialement au trou 32, le deuxième niveau fonctionnel F₂ s'étend un moyeu 34 à partir de la périphérie duquel se projette orthogonalement une denture 37 rejoignant le moyeu 24 du premier niveau fonctionnel F₁. A la figure 9, on s'aperçoit donc que l'épaisseur de la planche 33, c'est-à-dire du moyeu 34, ainsi que de la denture 37 sont formées par l'épaisseur e₁ de la couche 15 déposée lors de l'étape b du procédé.

Avantageusement, la matière est sélectivement déposée en ne déposant que la quantité de matière nécessaire au revêtement final sans qu'une opération de retouche soit rendue nécessaire. Il en résulte un abaissement du taux de rebut qui était imputable à l'opération d'enlèvement de matière (détérioration du substrat 1, éclat sur le dépôt 15, 17, etc.). Cela permet également un abaissement du coût de production généré par le raccourcissement de l'étape b de dépôt, de la moindre utilisation de matière du matériau 15, 17 et de l'absence d'opération de rodage mécanique de zones de contact prévues.

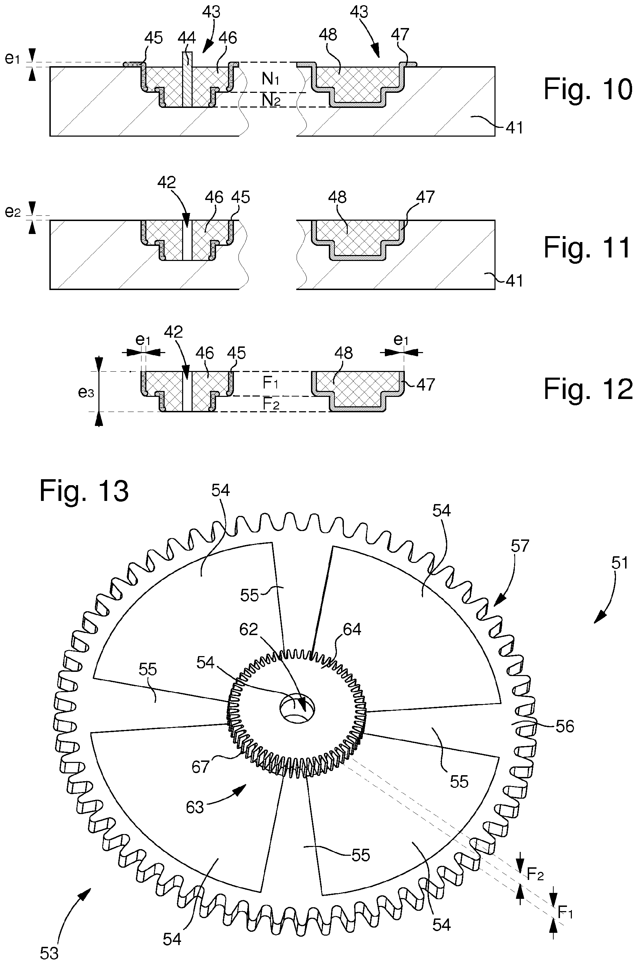

Un deuxième mode de réalisation est présenté aux figures 10 à 12. Les étapes a et b selon le deuxième mode de réalisation sont identiques au premier mode de réalisation et consiste à former, dans un substrat 41, une empreinte 43 négative sur au moins deux niveaux N₁, N₂, Nₓ, qui est revêtue au moins partiellement d'une couche 45, 47 de matériau à base d'un allotrope synthétique du carbone formant la future pièce de micromécanique avec les mêmes alternatives et avantages que le premier mode de réalisation.

Toutefois, comme illustré à la figure 10, une étape e est réalisée avant l'étape c, qui consiste à remplir l'empreinte 3 revêtue du matériau 45, 47 à base d'un allotrope synthétique du carbone avec un deuxième matériau afin qu'après l'étape c, on obtienne une pièce de micromécanique en un matériau 45, 47 à base d'un allotrope synthétique du carbone renforcé et/ou décoré par un deuxième matériau 46, 48.

Selon une première alternative représentée dans la partie droite de la figure 10, le deuxième matériau 48 est directement déposé pour remplir totalement le reste de l'empreinte 3 déjà recouverte par la couche 47 lors de l'étape b.

Selon une deuxième alternative représentée dans la partie gauche de la figure 10, une phase e₋₁ antérieure à l'étape e destinée à former un volume sacrificiel et une phase postérieure e₊₁ à l'étape e destinée à retirer le volume sacrificiel sont mis en œuvre afin de limiter la présence du deuxième matériau 46 lors de l'étape e. Dans l'exemple illustré à la figure 10, la phase e₋₁ antérieure permet de former une tige 44 afin que, lors de la phase e₊₁ postérieure, un trou 42 illustré à la figure 11 dénié de deuxième matériau 46 soit formé. A titre non limitatif, la tige 44 peut être formée par une photolithographie d'une résine photosensible du type négatif ou positif puis retirée par une dissolution ou une attaque chimique sélective. En variante, la tige 44 peut également être réalisée lors de l'étape a, c'est-à-dire que la tige 44 serait formée par une partie du substrat 41.

Préférentiellement, l'étape e de remplissage des creux est effectuée par un dépôt galvanique ou une déformation à chaud. La galvanoplastie est d'autant plus facile à effectuer si le substrat est réalisé en un matériau conducteur comme du silicium fortement dopé. Le deuxième matériau est, de manière préférée, un métal ou un alliage métallique qui peut être ou non amorphe. Toutefois, rien n'empêche alternativement de changer le type de dépôt et/ou la nature du matériau déposé. De manière analogue, la galvanoplastie peut être facilitée en rendant électriquement conducteur le matériau 45, 47 à base d'un allotrope synthétique du carbone, c'est-à-dire, par exemple, en déposant, lors de l'étape b, du diamant dopé avec du bore pour le rendre électriquement conducteur.

Par conséquent, dans ce deuxième mode de réalisation, l'étape optionnelle d peut être utilisée pour circonscrire l'épaisseur de la couche 45, 47 dans l'empreinte négative 43 sur plusieurs niveaux N₁, N₂, Nₓ, mais également à rendre plan le dépôt du deuxième matériau 46, 48 par rapport à la partie circonscrite.

Ainsi, éventuellement après l'étape optionnelle d et, après l'étape c, similaires au premier mode de réalisation, illustrée à la figure 12, on obtient une pièce de micromécanique à plusieurs niveaux fonctionnels F₁, F₂, Fₓ, en un premier matériau 45, 47 selon les mêmes variantes et avantages que le premier mode de réalisation, le premier matériau 45, 47 étant en plus renforcé et/ou décoré par un deuxième matériau 46, 48.

Selon un autre avantage, il est désormais possible de recouvrir des pièces à plusieurs niveaux fonctionnels F₁, F₂, Fₓ, avec des couches minces qu'il n'était pas possible de fabriquer auparavant à cause des conditions particulières de dépôt de la couche mince comme, par exemple, la pression, la température ou les composés utilisés. A titre non limitatif, de manière avantageuse, il est ainsi possible de former une pièce à plusieurs niveaux fonctionnels F₁, F₂, Fₓ, principalement métallique à partir du deuxième matériau 46, 48 qui est revêtue d'une couche de matériau à base d'un allotrope synthétique du carbone à partir de la couche 45, 47 alors qu'actuellement, il reste difficile à la connaissance de la Demanderesse de revêtir une pièce métallique avec du diamant.

On comprend également que l'on peut obtenir une pièce de micromécanique selon les mêmes complexités que le premier mode de réalisation. A titre d'exemple nullement limitatif, une pièce de micromécanique 51 susceptible d'être obtenue selon le deuxième mode de réalisation est présentée à la figure 13. La pièce de micromécanique 51 comporte un premier niveau fonctionnel F₁ composé d'une première planche 53 sensiblement discoïdale dont le centre comporte un trou communiquant avec un deuxième niveau fonctionnel F₂. De plus, coaxialement au trou, le premier niveau fonctionnel F₁ s'étend un moyeu reliant plusieurs bras 55 à la serge 56 à partir de la périphérie de laquelle se projette orthogonalement une denture 57. Enfin, le reste du premier niveau fonctionnel F₁ est rempli par le deuxième matériau 54 à l'exception du vide formé par le trou traversant 62.

En outre, la pièce de micromécanique 51 comporte un deuxième niveau fonctionnel F₂ composé d'une deuxième planche 63 sensiblement discoïdale dont le centre comporte un trou 62 permettant de coopérer avec un axe. De plus, coaxialement au trou 62, le deuxième niveau fonctionnel F₂ s'étend un moyeu 64 à partir de la périphérie duquel se projette orthogonalement une denture 67 rejoignant le moyeu du premier niveau fonctionnel F₁. Enfin, le reste du deuxième niveau fonctionnel F₂ est rempli par le deuxième matériau 54 à l'exception du vide formé par le trou traversant 62.

En variante, la pièce 51 pourrait avantageusement comporter des structures de renforcement des parties 55. Typiquement, ces structures pourraient par exemple renforcer en flexion les parties 55. Différentes formes de structures telles que radiales ou striées, pourraient apporter un gain en rigidité et être formées dans le substrat à l'aide du premier masque.

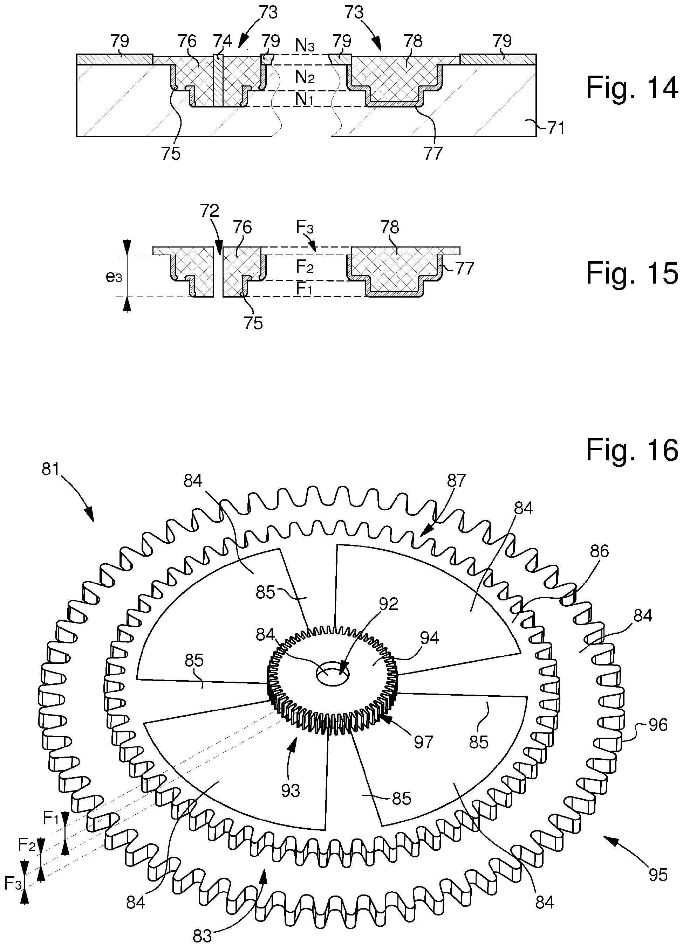

Un troisième mode de réalisation proche du deuxième mode de réalisation est présenté aux figures 14 et 15. Par rapport aux premier et deuxième modes de réalisation, les étapes a à c restent identiques. Toutefois, l'étape e du deuxième mode de réalisation est modifiée.

Ainsi, dans le troisième mode de réalisation après les étapes a, b, et, éventuellement, l'étape d, le procédé comporte une phase e₋₁ antérieure similaire à celle du deuxième mode de réalisation afin de former un volume sacrificiel 79 destiné à créer un niveau supérieur au niveau N₃ uniquement pour le deuxième matériau 76, 78 et, éventuellement, une tige 74 pour former un trou 72 comme pour le deuxième mode de réalisation.

Comme illustré à la figure 14, lors de l'étape e, le deuxième matériau 76, 78 est formé en saillie de ladite empreinte afin de former un niveau fonctionnel supplémentaire à la pièce de micromécanique. Ainsi, après une phase e₊₁ postérieure similaire à celle du deuxième mode de réalisation afin de retirer le volume sacrificiel 79 et, éventuellement, la tige 74 et l'étape c similaire aux deuxième premiers modes de réalisation, on obtient, comme illustrée à la figure 15, une pièce de micromécanique en un premier matériau 75, 77 renforcé et/ou décoré par un deuxième matériau 76, 78 selon les mêmes variantes et avantages que les premier F₁ et deuxième F₂ niveaux fonctionnels du deuxième mode de réalisation avec en plus un troisième niveau F₃ formé exclusivement avec le deuxième matériau 76, 78 en saillie de l'épaisseur e₃ afin de former un niveau fonctionnel F₃ supplémentaire à la pièce de micromécanique.

On comprend également que l'on peut obtenir une pièce de micromécanique selon les mêmes complexités que les deux premiers modes de réalisation. A titre d'exemple nullement limitatif, une pièce de micromécanique 81 susceptible d'être obtenue selon le troisième mode de réalisation est présentée à la figure 16. La pièce de micromécanique 81 comporte un premier niveau fonctionnel F₁ composé d'une première planche 93 sensiblement discoïdale dont le centre comporte un trou 92 permettant de coopérer avec un axe. De plus, coaxialement au trou 92, le premier niveau fonctionnel F₁ s'étend un moyeu 94 à partir de la périphérie duquel se projette orthogonalement une denture 97 rejoignant le deuxième niveau fonctionnel F₂. Enfin, le reste du premier niveau fonctionnel F₁ est rempli par le deuxième matériau 84 à l'exception du vide formé par le trou traversant 92.

La pièce de micromécanique 81 comporte un deuxième niveau fonctionnel F₂ composé d'une deuxième planche 83 sensiblement discoïdale dont le centre comporte un trou communiquant avec le premier niveau fonctionnel F₁. De plus, coaxialement au trou, le deuxième niveau fonctionnel F₂ s'étend un moyeu reliant plusieurs bras 85 à la serge 86 à partir de la périphérie de laquelle se projette orthogonalement une denture 87. Enfin, le reste du deuxième niveau fonctionnel F₂ est rempli par le deuxième matériau 84 à l'exception du vide formé par le trou traversant 92.

Avantageusement selon le troisième mode de réalisation, la pièce de micromécanique 81 comporte un troisième niveau fonctionnel F₃ composé d'une troisième planche 95 sensiblement discoïdale dont le centre comporte un trou communiquant avec le deuxième niveau fonctionnel F₂. Le troisième niveau fonctionnel F₃ est formé uniquement par le deuxième matériau 84 à l'exception du vide formé par le trou traversant 92 et comporte une denture périphérique 96.

Les trois modes de réalisation des figures 1 à 16 du procédé permettent donc avantageusement de diminuer très sensiblement le coût du matériau 15, 17, 45, 47, 75, 77 à base d'un allotrope synthétique du carbone en ne déposant que la quantité de matière nécessaire au revêtement final sans qu'une opération de retouche soit rendue nécessaire. Les trois modes de réalisation des figures 1 à 16 permettent également d'améliorer la rugosité de la surface externe de la pièce de micromécanique 21, 51, 81 pour parfaire sa tribologie. La pièce de micromécanique 21, 51, 81 obtenue est avantageusement monobloc, c'est-à-dire sans discontinuité de matière, creuse ou remplie, c'est-à-dire formée par une coque du matériau 15, 17, 45, 47, 75, 77 pour limiter la quantité de matériau à base d'un allotrope synthétique du carbone et, éventuellement, rempli par un deuxième matériau 46, 48, 54, 76, 78, 84, dont le volume forme plusieurs niveaux fonctionnels F₁, F₂, F₃, Fₓ, parfaitement référencés et pouvant comporter directement un axe de pivotement formé par le deuxième matériau.

On comprend toutefois que les trois modes de réalisation des figures 1 à 16 sont susceptibles de combinaisons entre eux et/ou de modifications suivant les applications souhaitées.

A titre d'exemples nullement limitatifs, des quatrième et cinquième modes de réalisation sont présentés aux figures 19 à 26 en combinant et modifiant des alternatives du premier mode de réalisation. On comprend que ces quatrième et cinquième modes de réalisation sont également susceptibles d'être combinés avec les trois premiers modes de réalisation des figures 1 à 16.

Les quatrième et cinquième modes de réalisation selon l'invention utilisent tous les deux une modification de la deuxième alternative de l'étape a illustrée aux figures 17 et 18. Dans les quatrième et cinquième modes de réalisation, on forme un substrat, comportant une empreinte sur au moins trois niveaux N₁, N₂, Nₓ, à partir de trois plaquettes. Ainsi dans le quatrième mode de réalisation illustré aux figures 19 à 22, on utilise deux plaquettes gravées selon un motif particulier formant un ou plusieurs niveaux N₁, N₂, Nₓ, associés.

Selon une variante déjà évoquée ci-dessus, une des plaquettes pourrait également être remplacée par un S.O.I. afin que le fond de l'empreinte soit formé par la couche de dioxyde de silicium.

Selon une première alternative de l'étape a du quatrième mode de réalisation illustrée à gauche des figures 19 et 20, deux plaquettes 202, 204 sont gravées selon le motif requis pour son niveau N₁, N₂, associé et une troisième plaquette 206 est laissée non gravée, c'est-à-dire ne comportant aucun motif traversant. Ainsi, dans la première alternative de l'étape a, une première phase a10 est destinée à former une première plaquette 202 comportant un premier motif 205 gravé traversant, une deuxième phase a11 destinée à former une deuxième plaquette 204 comportant un deuxième motif 207 gravé traversant et une troisième phase a12 consistant à former une troisième plaquette 206 ne comportant aucun motif gravé. Dans une dernière phase a13, l'étape a selon la première alternative du quatrième mode de réalisation se termine en solidarisant les plaquettes 202, 204, 206 à l'aide des couches 208, 210 formées par « fusion bonding » afin de former le substrat 201 comportant une empreinte 203 négative sur au moins trois niveaux N₁, N₂, formée respectivement des premier 205 et deuxième 207 motifs.

Après l'étape a, la première alternative du quatrième mode de réalisation se poursuit avec l'étape b destinée à recouvrir l'empreinte 203 négative du substrat 201 d'une couche 215 du matériau à base d'un allotrope synthétique du carbone d'une épaisseur e₁ inférieure à la profondeur de chacun desdits au moins trois niveaux N₁, N₂, de ladite empreinte 203.

La première alternative du quatrième mode de réalisation du procédé peut également comporter une troisième étape optionnelle d ou des phases similaires aux phases b1, b5 et b3, b7 pour circonscrire la couche 215 dans l'empreinte 203. De même, une autre étape optionnelle e peut être réalisée avant l'étape c, qui consiste à remplir l'empreinte 203 revêtue du matériau 215 à base d'un allotrope synthétique du carbone avec un deuxième matériau afin qu'après l'étape c, on obtienne une pièce de micromécanique en un matériau 215 à base d'un allotrope synthétique du carbone renforcé et/ou décoré par un deuxième matériau comme dans les deuxième et troisième modes de réalisation cités ci-dessus.

Dans une dernière étape c de la première alternative du quatrième mode de réalisation, le procédé consiste à retirer le substrat 201 afin de libérer la pièce de micromécanique à plusieurs niveaux fonctionnels F₁, F₂, formée au moins partiellement dans l'empreinte 203 selon les mêmes variantes et avantages que les trois premiers modes de réalisation.

Dans la première alternative illustrée à gauche de la figure 22, on obtient une pièce de micromécanique formée exclusivement par la couche 215 de géométrie correspondante à l'empreinte 203. Avantageusement, la surface externe, c'est-à-dire la surface qui était directement en contact avec le substrat 201, comporte une très bonne rugosité, c'est-à-dire comparable à celle du substrat 201, et est, préférentiellement, utilisée comme surface de contact mécanique.

Dans l'exemple illustré à gauche de la figure 22, on peut imaginer la formation d'une applique horlogère 221, c'est-à-dire une partie d'un afficheur. On obtient donc une pièce de micromécanique 221 comportant un premier niveau fonctionnel F₁ composé de pieds 227 destinés à coopérer avec un cadran de pièce d'horlogerie et d'un deuxième niveau fonctionnel F₂ composé d'un corps principal 223 creux formant la partie visible de l'applique 221. A la figure 22, on s'aperçoit donc que l'épaisseur du corps principal 223 et des pieds 227 sont formées par l'épaisseur e₁ de la couche 215 déposée lors de l'étape b du procédé.

Selon une deuxième alternative de l'étape a du quatrième mode de réalisation illustrée à droite des figures 19 et 20, deux plaquettes 302, 304 sont gravées selon un motif particulier requis pour un ou plusieurs niveaux N₁, N₂, N₃, et une troisième plaquette 306 est laissée non gravée, c'est-à-dire ne comportant aucun motif traversant. Ainsi, dans la deuxième alternative de l'étape a, une première phase a14 est destinée à former une première plaquette 302 comportant un premier motif 305 gravé traversant, une deuxième phase a15 destinée à former une deuxième plaquette 304 comportant un deuxième motif 307 gravé traversant et un troisième motif 311 gravé non traversant et communiquant avec le deuxième motif 307. L'étape a comporte également une troisième phase a16 consistant à former une troisième plaquette 306 ne comportant aucun motif gravé. Dans une dernière phase a17, l'étape a selon la deuxième alternative du quatrième mode de réalisation se termine en solidarisant les plaquettes 302, 304, 306 à l'aide des couches 308, 310 formées par « fusion bonding » afin de former le substrat 301 comportant une empreinte 303 négative sur trois niveaux N₁, N₂, N₃, formée respectivement des motifs 305, 311, 307.

Après l'étape a, la deuxième alternative du quatrième mode de réalisation se poursuit avec l'étape b destinée à recouvrir l'empreinte 303 négative du substrat 301 d'une couche 315 du matériau à base d'un allotrope synthétique du carbone d'une épaisseur e₁ inférieure à la profondeur de chacun desdits trois niveaux N₁, N₂, N₃, de ladite empreinte 303.

La deuxième alternative du quatrième mode de réalisation du procédé selon l'invention peut également comporter une troisième étape optionnelle d ou des phases similaires aux phases b1, b5 et b3, b7 pour circonscrire la couche 315 dans l'empreinte 303. De même, une autre étape optionnelle e peut être réalisée avant l'étape c, qui consiste à remplir l'empreinte 303 revêtue du matériau 315 à base d'un allotrope synthétique du carbone avec un deuxième matériau afin qu'après l'étape c, on obtienne une pièce de micromécanique en un matériau 315 à base d'un allotrope synthétique du carbone renforcé et/ou décoré par un deuxième matériau comme dans les deuxième et troisième modes de réalisation cités ci-dessus.

Dans une dernière étape c de la deuxième alternative du quatrième mode de réalisation, le procédé consiste à retirer le substrat 301 afin de libérer la pièce de micromécanique à plusieurs niveaux fonctionnels F₁, F₂, F₃, formée au moins partiellement dans l'empreinte 303 selon les mêmes variantes et avantages que les trois premiers modes de réalisation.

Dans la deuxième alternative illustrée à droite de la figure 22, on obtient une pièce de micromécanique formée exclusivement par la couche 315 de géométrie correspondante à l'empreinte 303. Avantageusement, la surface externe, c'est-à-dire la surface qui était directement en contact avec le substrat 301, comporte une très bonne rugosité, c'est-à-dire comparable à celle du substrat 301, et est, préférentiellement, utilisée comme surface de contact mécanique.

Dans l'exemple illustré à droite de la figure 22, on peut imaginer la formation d'un cadran horloger 321. On obtient donc une pièce de micromécanique 321 comportant un premier niveau fonctionnel F₁ composé de pieds 327 destinés à coopérer avec une platine de pièce d'horlogerie. La pièce de micromécanique 321 comporte également un deuxième niveau fonctionnel F₂ composé d'un corps principal 323 creux formant la majeure partie visible du cadran et un troisième niveau fonctionnel F₃ formant au moins une excroissance du corps principal 325 apte à servir d'applique 325 monobloc. A la figure 22, on s'aperçoit donc que l'épaisseur du corps principal 323, de l'excroissance 325 et des pieds 327 sont formées par l'épaisseur e₁ de la couche 315 déposée lors de l'étape b du procédé.

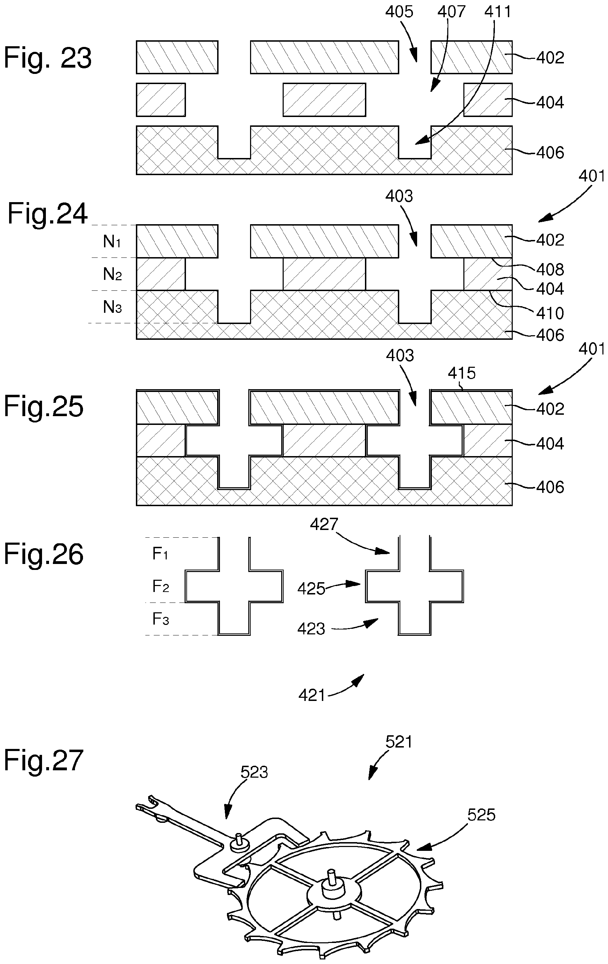

Selon l'étape a du cinquième mode de réalisation illustrée aux figures 23 et 24, trois plaquettes 402, 404, 406 sont gravées selon un motif requis pour un niveau N₁, N₂, N₃, associé. Ainsi, dans l'étape a, une première phase a18 est destinée à former une première plaquette 402 comportant un premier motif 405 gravé traversant, une deuxième phase a19 destinée à former une deuxième plaquette 404 comportant un deuxième motif 407 gravé traversant et une troisième phase a20 consistant à former une troisième plaquette 406 comportant un motif gravé non traversant 411, c'est-à-dire ne comportant aucun motif traversant. Dans une dernière phase a21, l'étape a selon le cinquième mode de réalisation se termine en solidarisant les plaquettes 402, 404, 406 à l'aide des couches 408, 410 formées par « fusion bonding » afin de former le substrat 401 comportant une empreinte 403 négative sur trois niveaux N₁, N₂, N₃, formée respectivement des motifs 405, 407 et 411.

Après l'étape a, le cinquième mode de réalisation se poursuit avec l'étape b destinée à recouvrir l'empreinte 403 négative du substrat 401 d'une couche 415 du matériau à base d'un allotrope synthétique du carbone d'une épaisseur e₁ inférieure à la profondeur de chacun desdits trois niveaux N₁, N₂, N₃, de ladite empreinte 403.

Le cinquième mode de réalisation du procédé selon l'invention peut également comporter une troisième étape optionnelle d ou des phases similaires aux phases b1, b5 et b3, b7 pour circonscrire la couche 415 dans l'empreinte 403. De même, une autre étape optionnelle e peut être réalisée avant l'étape c, qui consiste à remplir l'empreinte 403 revêtue du matériau 415 à base d'un allotrope synthétique du carbone avec un deuxième matériau afin qu'après l'étape c, on obtienne une pièce de micromécanique en un matériau 415 à base d'un allotrope synthétique du carbone renforcé et/ou décoré par un deuxième matériau comme dans les deuxième et troisième modes de réalisation cités ci-dessus.

Dans une dernière étape c du cinquième mode de réalisation, le procédé consiste à retirer le substrat 401 afin de libérer la pièce de micromécanique à plusieurs niveaux fonctionnels F₁, F₂, F₃, formée au moins partiellement dans l'empreinte 403 selon les mêmes variantes et avantages que les trois premiers modes de réalisation.

Dans l'exemple illustré à la figure 26, on obtient une pièce de micromécanique formée exclusivement par la couche 415 de géométrie correspondante à l'empreinte 403. Avantageusement, la surface externe, c'est-à-dire la surface qui était directement en contact avec le substrat 401, comporte une très bonne rugosité, c'est-à-dire comparable à celle du substrat 401, et est, préférentiellement, utilisée comme surface de contact mécanique.

Dans l'exemple illustré à la figure 26, on peut imaginer la formation d'un mobile horloger 421. On obtient donc une pièce de micromécanique 421 comportant un premier niveau fonctionnel F₁ composé d'un pivot 427 destiné à coopérer avec un premier palier de pièce d'horlogerie. La pièce de micromécanique 421 comporte également un deuxième niveau fonctionnel F₂ composé d'un corps évasé 425 creux formant une roue avec une denture et un troisième niveau fonctionnel F₃ composé d'un deuxième pivot 423 destiné à coopérer avec un deuxième palier de pièce d'horlogerie. A la figure 26, on s'aperçoit donc que l'épaisseur des pivots 423, 427 et de la roue 425 sont formées par l'épaisseur e₁ de la couche 415 déposée lors de l'étape b du procédé.

Par conséquent, on comprend que le procédé permet de former une pièce de micromécanique comportant plusieurs niveaux fonctionnels F₁, F₂, F₃, Fₓ, sans limitation de hauteur. A titre d'exemple nullement limitatif illustré à la figure 27, il est ainsi possible de former un échappement 521 à ancre suisse entièrement en diamant. Ainsi, on s'aperçoit qu'il est possible que l'épaisseur de l'ancre 523 creuse et monobloc, c'est-à-dire les palettes, la tige, la baguette, la fourchette et le dard, soit formée uniquement par l'épaisseur e₁ de la couche déposée lors de l'étape b du procédé selon l'invention. De manière analogue il est également possible que l'épaisseur de la roue d'échappement 525 creuse et monobloc, c'est-à-dire la roue et les pivots, soit formée uniquement par l'épaisseur e₁ de la couche déposée lors de l'étape b du procédé selon l'invention.

Bien entendu, la présente invention ne se limite pas à l'exemple illustré mais est susceptible de diverses variantes et modifications qui apparaîtront à l'homme de l'art. En particulier, plusieurs pièces 21, 51, 81, 221, 321, 421, 523, 525 de micromécanique de motif identique ou non peuvent être fabriquées en même temps sur un même substrat 1, 41, 71, 101, 201, 301, 401 et, éventuellement, même un S.O.I..

Par conséquent, non seulement plusieurs empreintes 3, 43, 73, 103, 203, 303, 403 identiques ou non peuvent être formées sur le substrat 1, 41, 71, 101, 201, 301, 401 mais elles peuvent l'être également sur plusieurs faces du substrat 1, 41, 71, 101, 201, 301, 401, c'est-à-dire que les étapes des différents modes de réalisation du procédé peuvent être appliquées à plusieurs faces du substrat 1, 41, 71, 101, 201, 301, 401.

## Revendications

1. Procédé de fabrication d'une pièce (321, 421, 523, 525) de micromécanique creuse en un matériau (315, 415) monobloc à base d'un allotrope synthétique du carbone, le procédé comportant les étapes suivantes :
a) former un substrat (301, 401) comportant sur au moins trois niveaux (N₁, N₂, N₃, Nₓ) une empreinte (303, 403) négative de ladite pièce de micromécanique à fabriquer ;
b) recouvrir ladite empreinte (303, 403) négative du substrat (301, 401) d'une couche dudit matériau à base d'un allotrope synthétique du carbone d'une épaisseur (e₁) inférieure à la profondeur de chacun desdits au moins trois niveaux (N₁, N₂, N₃, Nₓ) de ladite empreinte ;
c) retirer le substrat (301, 401) afin de laisser libre la pièce de micromécanique creuse (321, 421, 523, 525) monobloc formée dans ladite empreinte négative ;
l'étape a) comporte les phases suivantes :
i) former une première plaquette (302, 402) comportant au moins un premier motif (305, 405) gravé traversant ;
ii) former une deuxième plaquette (304, 404) comportant au moins un deuxième motif (307, 311, 407) gravé traversant ;
iii) former une troisième plaquette ( 306, 406) ne comportant aucun motif traversant ;
iv) solidariser lesdites première, deuxième et troisième plaquettes afin de former le substrat (301, 401) comportant une empreinte négative sur au moins trois niveaux.

2. Procédé selon la revendication précédente, **caractérisé en ce que**, lors de la phase ii), la deuxième plaquette (304) est formée en comportant un deuxième motif (307) gravé traversant et un troisième motif (311) gravé non traversant et communiquant avec ledit deuxième motif (307).

3. Procédé selon l'une des revendications précédentes, **caractérisé en ce que**, lors de la phase iii), la troisième plaquette (406) est formée en comportant un motif (411) gravé non traversant.

4. Procédé selon l'une des revendications précédentes, **caractérisé en ce que** l'étape b) comporte les phases suivantes :
b1) former une couche sacrificielle (11) sur une partie du substrat ;
b2) déposer des particules (13) sur le substrat (301, 401) destinées à former des lieux de germination ;
b3) retirer la couche sacrificielle (11) afin de laisser sélectivement libre de toute particule, une partie du substrat (301, 401);
b4) déposer, chimiquement en phase vapeur, une couche (315, 415) d'un allotrope synthétique du carbone afin qu'elle se dépose uniquement où subsistent les particules (13).

5. Procédé selon l'une des revendications 1 à 3, **caractérisé en ce que** l'étape b) comporte les phases suivantes :
b5) former une couche sacrificielle (11) sur une partie du substrat (301, 401) ;
b6) déposer, chimiquement en phase vapeur, une couche (315, 415) d'un allotrope synthétique du carbone sur le substrat.
b7) retirer la couche sacrificielle (11) afin de laisser sélectivement libre de tout dépôt, une partie du substrat (301,401).

6. Procédé selon l'une des revendications précédentes, **caractérisé en ce qu'**au moins l'un desdits au moins trois niveaux (N₁, N₂, N₃, Nₓ) de l'empreinte (303, 403) négative comporte une paroi formant une denture.

7. Procédé selon l'une des revendications précédentes, **caractérisée en ce que** le matériau (315, 415) à base d'un allotrope synthétique du carbone est sous forme cristallisée.

8. Procédé selon la revendication 1 à 6, **caractérisée en ce que** le matériau (315, 415) à base d'un allotrope synthétique du carbone est sous forme amorphe.

9. Procédé selon l'une des revendications précédentes, **caractérisé en ce qu'**il comporte, après l'étape b), l'étape suivante :
d) retirer du substrat (301, 401) une épaisseur supérieure à celle de la couche déposée lors de l'étape b) afin de laisser une épaisseur de ladite couche circonscrite dans ladite empreinte négative.

10. Procédé selon l'une des revendications précédentes, **caractérisé en ce qu'**il comporte, avant l'étape c), l'étape suivante :
e) remplir l'empreinte (303, 403) revêtue du matériau (315, 415) à base d'un allotrope synthétique du carbone avec un deuxième matériau afin qu'après l'étape c), on obtienne une pièce de micromécanique (321, 421, 523, 525) en un matériau (315, 415) à base d'un allotrope synthétique du carbone renforcé et/ou décoré par un deuxième matériau.

11. Procédé selon la revendication précédente, **caractérisé en ce que**, lors de l'étape e), le deuxième matériau est formé en saillie de ladite empreinte afin de former un niveau fonctionnel supplémentaire (F₁, F₂, F₃, Fₓ) à la pièce de micromécanique (321, 421, 523, 525).

12. Procédé selon la revendication 10 ou 11, **caractérisé en ce que** le deuxième matériau comporte un métal ou un alliage métallique.

13. Pièce de micromécanique (321, 421, 523, 525) obtenue à partir du procédé selon l'une des revendications précédentes, en ce que la pièce de micromécanique (321, 421, 523, 525) comporte plusieurs niveaux fonctionnels (F₁, F₂, F₃, Fₓ) formés de manière monobloc en matériau (315, 415) à base d'un allotrope synthétique du carbone selon une couche d'épaisseur (e₁) comprise entre 0,2 µm et 20 µm et comprend une hauteur (e₃) supérieure à l'épaisseur (e₁) de la couche en matériau (315, 415) à base d'allotrope synthétique du carbone,
**caractérisée en ce que** la pièce de micromécanique est creuse.

14. Pièce (321, 421, 523, 525) selon la revendication précédente, **caractérisée en ce que** la surface externe de la pièce de micromécanique (321, 421, 523, 525) comporte au moins une denture.

15. Pièce (321, 421, 523, 525) selon la revendication 13 ou 14, **caractérisée en ce que** le creux de la pièce de micromécanique ( 321, 421, 523, 525) est au moins partiellement rempli avec un deuxième matériau afin d'obtenir une pièce de micromécanique (321, 421, 523, 525) en matériau (315, 415) à base d'un allotrope synthétique du carbone renforcé et/ou décoré par un deuxième matériau.

16. Pièce (321, 421, 523, 525) selon la revendication précédente, **caractérisée en ce que** ledit deuxième matériau est formé en saillie de ladite hauteur de la surface externe afin de former un élément fonctionnel supplémentaire (F₁, F₂, F₃, Fₓ) à la pièce de micromécanique (321, 421, 523, 525).

17. Pièce (321, 421, 523, 525) selon la revendication 15 ou 16, **caractérisée en ce que** le deuxième matériau comporte un métal ou un alliage métallique.

18. Pièce d'horlogerie **caractérisée en ce qu'**elle comporte une pièce de micromécanique (321, 421, 523, 525) selon l'une des revendications 13 à 17.

19. Pièce d'horlogerie selon la revendication 18, **caractérisée en ce que** la pièce de micromécanique (321, 421, 523, 525) forme tout ou partie d'une glace, d'un boîtier, d'un poussoir, d'une couronne, d'un bracelet, d'un cadran, d'un afficheur, d'un spiral, d'un balancier, d'une ancre, d'un pont, d'une platine, d'un mobile ou d'une roue d'échappement.

## Patentansprüche

1. Verfahren zum Herstellen eines hohlen mikromechanischen Bauteils (321, 421, 523, 525) aus einem Monoblockmaterial (315, 415) auf Basis eines synthetischen Kohlenstoffallotrops, wobei das Verfahren die folgenden Schritte umfasst:
a) Bilden eines Substrats (301, 401), das auf mindestens drei Ebenen (N₁, N₂, N₃, N_{X}) einen negativen Abdruck (303, 403) des herzustellenden mikromechanischen Bauteils aufweist;
b) Bedecken des negativen Abdrucks (303, 304) des Substrats (301, 401) mit einer Schicht aus dem Material auf Basis eines synthetischen Kohlenstoffallotrops mit einer Dicke (e₁), die geringer ist als die Tiefe jeder der mindestens drei Ebenen (N₁, N₂, N₃, N_{X}) des Abdrucks;
c) Entfernen des Substrats (301, 401), um das hohle mikromechanische Monoblock-Bauteil (321, 421, 523, 525), das in dem negativen Abdruck gebildet ist, frei zu lassen;
wobei der Schritt a) die folgenden Stufen umfasst:
i) Bilden einer ersten Platte (302, 402), die mindestens ein erstes durchgestochenes Muster (305, 405) aufweist;
ii) Bilden einer zweiten Platte (304, 404), die mindestens ein zweites durchgestochenes Muster (307, 311, 407) aufweist;
iii) Bilden einer dritten Platte (306, 406), die keinerlei durchgestochenes Muster aufweist;
iv) Befestigen der ersten, der zweiten und der dritten Platte aneinander, um das Substrat (301, 401), das auf mindestens drei Ebenen einen negativen Abdruck aufweist, zu bilden.

2. Verfahren nach dem vorhergehenden Anspruch, **dadurch gekennzeichnet, dass** in der Phase ii) die zweite Platte (304) so gebildet wird, dass sie ein zweites durchgestochenes Muster (307) und ein drittes eingestochenes nicht durchgehendes Muster (311) aufweist, das mit dem zweiten Muster (307) verbunden ist.

3. Verfahren nach einem der vorhergehenden Ansprüche, **dadurch gekennzeichnet, dass** in der Phase iii) die dritte Platte (406) so ausgebildet wird, dass sie ein eingestochenes nicht durchgehendes Muster (411) aufweist.

4. Verfahren nach einem der vorhergehenden Ansprüche, **dadurch gekennzeichnet, dass** der Schritt b) die folgenden Phasen umfasst:
b1) Bilden einer Opferschicht (11) auf einem Teil des Substrats;
b2) Ablagern von Partikeln (13) auf dem Substrat (301, 401), die dazu bestimmt sind, Anwachsstellen zu bilden;
b3) Entfernen der Opferschicht (11), um einen Teil des Substrats (301, 401) selektiv frei von jeglichem Partikel zu lassen;
b4) chemisches Abscheiden aus der Dampfphase einer Schicht (315, 415) eines synthetischen Kohlenstoffallotrops, so dass es nur dort abgelagert wird, wo die Partikel (13) verbleiben.

5. Verfahren nach einem der Ansprüche 1 bis 3, **dadurch gekennzeichnet, dass** der Schritt b) die folgenden Stufen umfasst:
b5) Bilden einer Opferschicht (11) auf einem Teil des Substrats (301, 401);
b6) chemisches Abscheiden aus der Dampfphase einer Schicht (315, 415) eines synthetischen Kohlenstoffallotrops auf dem Substrat;
b7) Entfernen der Opferschicht (11), um einen Teil des Substrats (301, 401) wahlweise frei von jeglicher Abscheidung zu lassen.

6. Verfahren nach einem der vorhergehenden Ansprüche, **dadurch gekennzeichnet, dass** mindestens eine der mindestens drei Ebenen (N₁, N₂, N₃, N_{X}) des negativen Abdrucks (303, 403) eine Wand aufweist, die eine Zahnung bildet.

7. Verfahren nach einem der vorhergehenden Ansprüche, **dadurch gekennzeichnet, dass** das Material (315, 415) auf Basis eines synthetischen Kohlenstoffallotrops in kristallisierter Form vorliegt.

8. Verfahren nach Anspruch 1 bis 6, **dadurch gekennzeichnet, dass** das Material (315, 415) auf Basis eines synthetischen Kohlenstoffallotrops eine amorphe Form aufweist.

9. Verfahren nach einem der vorhergehenden Ansprüche, **dadurch gekennzeichnet, dass** es nach dem Schritt b) den folgenden Schritt umfasst:
d) Entfernen einer Dicke von dem Substrat (301, 401), die größer als jene der im Schritt b) abgeschiedenen Schicht ist, um eine Dicke der in dem negativen Abdruck umgrenzten Schicht zu belassen.

10. Verfahren nach einem der vorhergehenden Ansprüche, **dadurch gekennzeichnet, dass** es vor dem Schritt c) den folgenden Schritt umfasst:
e) Füllen des Abdrucks (303, 403), der mit einem Material (315, 415) auf Basis eines synthetischen Kohlenstoffallotrops beschichtet ist, mit einem zweiten Material, um nach Schritt c) ein mikromechanisches Bauteil (321, 421, 523, 525) aus einem Material (315, 415) auf Basis eines synthetischen Kohlenstoffallotrops, das durch ein zweites Material verstärkt und/oder verziert ist, zu erhalten.

11. Verfahren nach dem vorhergehenden Anspruch, **dadurch gekennzeichnet, dass** in Schritt e) das zweite Material vorstehend von dem Abdruck geformt wird, um eine zusätzliche funktionale Ebene (F₁, F₂, F₃, F_{X}) an dem mikromechanischen Bauteil (321, 421, 523, 525) zu bilden.

12. Verfahren nach Anspruch 10 oder 11, **dadurch gekennzeichnet, dass** das zweite Material ein Metall oder eine Metalllegierung enthält.

13. Mikromechanisches Bauteil (321, 421, 523, 525), erhalten anhand des Verfahrens nach einem der vorhergehenden Ansprüche, wobei das mikromechanische Bauteil (321, 421, 523, 525) mehrere funktionale Ebenen (F₁, F₂, F₃, F_{X}) umfasst, die monoblockartig gebildet sind aus einem Material (315, 415) auf Basis eines synthetischen Kohlenstoffallotrops mit einer Schicht mit einer Dicke (e₁) im Bereich von 0,2 µm bis 20 µm und mit einer Höhe (e₃), die größer als die Dicke (e₁) der Schicht aus dem Material (315, 415) auf Basis eines synthetischen Kohlenstoffallotrops ist, **dadurch gekennzeichnet, dass** das mikromechanische Bauteil hohl ist.

14. Bauteil (321, 421, 523, 525) nach dem vorhergehenden Anspruch, **dadurch gekennzeichnet, dass** die äußere Oberfläche des mikromechanischen Bauteils (321, 421, 523, 525) mindestens eine Zahnung aufweist.

15. Bauteil (321, 421, 523, 525) nach Anspruch 13 oder 14, **dadurch gekennzeichnet, dass** der Hohlraum des mikromechanischen Bauteils (321, 421, 523, 525) zumindest teilweise mit einem zweiten Material gefüllt ist, um ein mikromechanisches Bauteil (321, 421, 523, 525) aus einem Material (315, 415) auf Basis eines synthetischen Kohlenstoffallotrops, das mit einem zweiten Material verstärkt und/oder verziert ist, zu erhalten.

16. Bauteil (321, 421, 523, 525) nach dem vorhergehenden Anspruch, **dadurch gekennzeichnet, dass** das zweite Material vorstehend von der Höhe der äußeren Oberfläche geformt ist, um ein zusätzliches funktionales Element (F₁, F₂, F₃, F_{X}) an dem mikromechanischen Bauteil (321, 421, 523, 525) zu bilden.

17. Bauteil (321, 421, 523, 525) nach Anspruch 15 oder 16, **dadurch gekennzeichnet, dass** das zweite Material ein Metall oder eine Metalllegierung enthält.

18. Uhr, **dadurch gekennzeichnet, dass** sie ein mikromechanisches Bauteil (321, 421, 523, 525) nach einem der Ansprüche 13 bis 17 enthält.

19. Uhr nach Anspruch 18, **dadurch gekennzeichnet, dass** das mikromechanische Bauteil (321, 421, 523, 525) ganz oder teilweise ein Uhrenglas, ein Gehäuse, einen Drücker, eine Krone, ein Armband, ein Zifferblatt, einen Zeiger, eine Spiralfeder, eine Unruh, einen Anker, eine Brücke, eine Platine, ein Drehteil oder ein Hemmungsrad bildet.

## Claims

1. Method for fabrication of a one-piece micromechanical part (221, 321, 421, 523, 525) made of a synthetic carbon allotrope based material (215, 315, 415), the method comprising the following steps:
a) forming a substrate (201, 301, 401) comprising, on at least three levels (N₁, N₂, N₃, Nₓ), a negative cavity (203, 303, 403) for the one-piece micromechanical part to be fabricated;
b) coating the negative cavity (203, 303, 403) of the substrate (201, 301, 401) with a layer of the synthetic carbon allotrope based material in a smaller thickness (e₁) than the depth of each at least three levels (N₁, N₂, N₃, Nₓ) of the negative cavity;
c) removing the substrate (201, 301, 401) to release the one-piece micromechanical part hollow, (221, 321, 421, 523, 525) formed in the negative cavity,
**characterized in that** step a) comprises the following phases:
i) forming a first wafer (202, 302, 402) comprising at least a first pattern (205, 305, 405) etched through;
ii) forming a second wafer (204, 304, 404) comprising at least a second pattern (207, 307, 311, 407) etched through;
iii) forming a third wafer (206, 306, 406) with no through pattern;
iv) bonding the first, second and third wafers in order to form the substrate (201, 301, 401) comprising the negative cavity on the at least three levels.

2. Method according to claim 1, **characterized in that**, in phase ii), the second wafer (304) is formed by including a second pattern (307) etched through and a third etched non-through pattern (311) communicating with the second pattern (307).

3. Method according to claim 1 or 2, **characterized in that**, in phase iii), the third wafer (406) is formed by including an etched non-through pattern (411).

4. Method according to any of claims 1 to 3, **characterized in that** step b) comprises the following phases:
b1) forming a sacrificial layer (11) on one portion of the substrate;
b2) depositing particles (13) on the substrate (201, 301, 401) intended to form nucleation sites;
b3) removing the sacrificial layer (5, 11) so as to selectively leave one portion of the substrate (201, 301, 401) free of any particles (13);
b4) chemical vapour phase depositing a layer (215, 315, 415) of a synthetic carbon allotrope based material so that the layer is deposited only where particles (13) remain.

5. Method according to any of claims 1 to 3, **characterized in that** step b) comprises the following phases:
b5) forming a sacrificial layer (11) on one portion of the substrate (201, 301, 401);
b6) chemical vapour phase depositing a layer (215, 315, 415) of a synthetic carbon allotrope based material on the substrate;
b7) removing the sacrificial layer (11) so as to selectively leave one portion of the substrate (201, 301, 401) free of any layer (215, 315, 415).

6. Method according to any of claims 1 to 5, **characterized in that** at least one of the at least three levels (N₁, N₂, N₃, Nₓ) of the negative cavity (203, 303, 403) comprises a wall forming a toothing.

7. Method according to any of claims 1 to 6, **characterized in that** the synthetic carbon allotrope based material (215, 315, 415) is in crystallized form.

8. Method according to any of claims 1 to 6, **characterized in that** the synthetic carbon allotrope based material (215, 315, 415) is in amorphous form.

9. Method according to any of claims 1 to 8, **characterized in that** after step b), the method comprises the following step:
d) removing from the substrate (201, 301, 401) a greater thickness than that of the layer deposited in step b), so as to leave the layer deposited in step b) only in the negative cavity.

10. Method according to any of claims 1 to 9, **characterized in that** prior to step c), the method comprises the following step:
e) filling the negative cavity (203, 303, 403), coated with the synthetic carbon allotrope based material (215, 315, 415), with a second material so that, after step c), obtaining the one-piece micromechanical part (221, 321, 421, 523, 525) formed of a synthetic carbon allotrope based material (215, 315, 415) strengthened by and/or decorated with a second material.

11. Method according to claim 10, **characterized in that**, in step e), the second material is formed projecting from the negative cavity in order to form an additional functional level (F₁, F₂, F₃, Fₓ) of the one-piece micromechanical part (221, 321, 421, 523, 525).

12. Method according to claim 10 or 11, **characterized in that** the second material comprises a metal or metal alloy.

13. Micromechanical part (221, 321, 421, 523, 525) in one piece obtained from a method according to any of claims 1 to 12, **characterized in that** the micromechanical part (221, 321, 421, 523, 525) comprises several functional levels (F₁, F₂, F₃, Fₓ) formed in a one-piece manner of a synthetic carbon allotrope based material (215, 315, 415) in a layer of thickness (e₁) comprised between 0.2µm and 20µm, the micromechanical part (221, 321, 421, 523, 525) in one piece comprising a height (e₃) greater than the thickness (e₁) of the layer of synthetic carbon allotrope based material (215, 315, 415).

14. Micromechanical part (221, 321, 421, 523, 525) in one piece according to claim 13, **characterized in that** the external surface of the micromechanical part (221, 321, 421, 523, 525) in one piece comprises at least one toothing.

15. Micromechanical part (221, 321, 421, 523, 525) in one piece according to claim 13 or 14, **characterized in that** the hollow of the micromechanical part (221, 321, 421, 523, 525) in one piece is at least partially filled with a second material in order to obtain a micromechanical part (221, 321, 421, 523, 525) in one piece formed of the synthetic carbon allotrope based material (215, 315, 415) strengthened by and/or decorated with a second material.

16. Micromechanical part (221, 321, 421, 523, 525) in one piece according to claim 15, **characterized in that** the second material is formed projecting from the height of the external surface in order to form an additional functional element (F₁, F₂, F₃, Fₓ) of the micromechanical part (221, 321, 421, 523, 525) in one piece.

17. Micromechanical part (21, 51, 81, 221, 321, 421, 523, 525) in one piece according to claim 15 or 16, **characterized in that** the second material comprises a metal or a metal alloy.

18. Timepiece **characterized in that** the timepiece comprises a micromechanical part (221, 321, 421, 523, 525) in one piece according to any of claims 13 to 17.

19. Timepiece according to claim 18, **characterized in that** the micromechanical part (221, 321, 421, 523, 525) in one piece forms all or part of a crystal, a case, a push-piece, a crown, a bracelet, a watchband, a dial, a display member, a balance spring, a balance wheel, a pallets, a bridge, a main plate, a wheel set or an escape wheel.
